# EUROPEAN PATENT APPLICATION

(11) **EP 3 761 364 A1**
(43) Date of publication of application: **06.01.2021**
(21) Application number: 19760179.2
(22) Date of filing: 01.03.2019
(51) Int. Cl.: H01L 27/15

(54) **DISPLAY COMPONENT AND DISPLAY DEVICE**

(30) Priority: 01.03.2018 WO PCT/CN2018/077715
(71) Applicant: HES IP Holdings, LLC, Ste 308 Spring TX 77386 (US)
(72) Inventor: CHEN, Tai Kuo, New Taipei City, Taiwan 236 (TW)
(74) Representative: Michalski Hüttermann & Partner Patentanwälte mbB
(86) International application number: PCT/CN2019/076752
(87) International publication number: WO 2019/166018

(57) **Abstract**

Disclosed is a display assembly which comprises a substrate, a plurality of light emitting units, a transistor unit and a capacitor unit corresponding to each of the plurality of light emitting units. Each of the plurality of light emitting units is electrically coupled to the corresponding transistor unit and the capacitor unit, all of which are independently provided on a side of the substrate. A spacing between each of the plurality of light emitting units is at least two times of a first threshold length.

## Description

### CROSS-REFERENCE TO RELATED APPLICATIONS

This non-provisional application claims priority under 35 U.S.C. § 119(a) on Patent Application No(s). PCT/CN2018/077715 on March 1, 2018, the entire contents of which are hereby incorporated by reference.

### FIELD OF THE INVENTION

The present invention is related to a display assembly; more particularly, a display device comprising the display assembly.

### BACKGROUND OF THE INVENTION

As the demand for real-time information rises, the importance of on-demand data transmission is also increased. Near-eye displays (NED) can be easily incorporated into other devices and can transmit images, colors, texts and/or sound data at any time; therefore, it is a primary choice for portable information device or on-demand data transmission purposes. Near-eye displays are often implemented for military or governmental uses in the past. Currently, the near-eye display industry seeks expansion in the consumer sector. Meanwhile, the entertainment industry also sees the market potential in near-eye displays; for example, home entertainment system and gaming software developers have been putting effort into research and development of near-eye displays.

Currently, a typical near-eye display includes head-mounted display (HMD), which can project image directly into users' eyes. This type of display can emulate bigger displays to overcome the shortcomings of the displays in mobile devices. The head-mounted display can also be applied to virtual reality or augmented reality uses.

Near-eye displays can be further categorized into two types: immersive display and see-through display. In virtual reality (VR) environment, an immersive display can be implemented to enable composite images to completely cover the visual field of a user. In augmented reality (AR) environment, a see-through display is implemented; and therefore, texts, side notes or images can be overlapped with real images. In the field of augmented reality display technology, a transparent panel (implemented via optical or electro-optical means) is often used in a see-through display. This enables the user of the near-eye display to see both virtual images and real images in the same time.

However, since human eyes cannot focus on objects placed at a very close distance (for example, when a user is wearing glasses and using a magnify lens as a reading aid, a distance within the range of the magnify lens and the glasses is considered "close distance"); therefore, the near-eye display needs to be calibrated and adjusted to avoid image being out of focus so as to provide a comfortable using experience for the users. The traditional near-eye displays rely on complex and heavy optical assembly to adjust the focus of the image; however, since near-eye display is usually worn on the user's head, heavier near-eye displays oftentimes cannot be accepted by the users.

To overcome the above mentioned shortcomings, if one can enable at least two light beams emitted by at least two separate pixels to intersect and focus to produce a clear image; heavy optical assembly would no longer be necessary; furthermore, the manufacturing cost arisen from the optical assembly would be eliminated.

### SUMMARY OF THE INVENTION

The purpose of the present invention is to provide an advantageous display assembly for a near-eye display for manufacturing a see-through display device.

In order to achieve the aforementioned purpose, the present invention provides a display assembly comprising a substrate; a plurality of light emitting units; and a transistor unit and a capacitor unit corresponding to each of the light emitting units. Each of the light emitting units and the corresponding transistor unit and capacitor unit are independently provided on a side of the substrate. And each of the light emitting units is electrically coupled to the corresponding transistor unit and the capacitor unit. A spacing between each of the light emitting units is at least two times of a first threshold length.

The phrase "independently provided" used in the present invention means the plurality of light emitting units only comprises the light emitting body, but not other parts that would block the light emitting body, such as transistors, or capacitors... etc.

The display assembly in the prior art is an assembly comprised of pixels. The pixels may respectively comprise a light emitting body, a transistor, a capacitor... etc. The transistor and the capacitor may partially block the light emitting body, causing the light emission efficiency to decrease. Based on this reason, the light emitting units in the present invention are independently provided. Relative to the prior art, the light emitting units of the present invention have greater light emission efficiency compare to the light emission body of the prior art having the same area. As a result, the area of the light emitting units can be decreased relative to the prior art.

In some embodiments of the present invention, each of the light emitting units in the display assembly comprises a red light emitter, a green light emitter, and a blue light emitter, respectively. In some embodiments of the present invention, the light emitting units in the display assembly comprise one or more light emitting body subunits, respectively; and each of the light emitting body subunits comprises a red light emitting body, a green light emitting body, and a blue light emitting body.

In some embodiments of the present invention, the light emitting units in the display assembly comprise 1 to 6 light emitting body subunits. In some embodiments of the present invention, the light emitting units in the display assembly comprise 2 to 4 light emitting body subunits.

In some embodiments of the present invention, the area of each of the light emitting units in the display assembly is smaller than that of the pixel in the prior art (the smallest is 6.3×6.3µm²); the area difference is at least two times or dozens of times. In some embodiments of the present invention, the area of each of the light emitting body subunits in the display assembly is smaller than 1× 1µm².

In some embodiments of the present invention, the spacing between each of the light emitting units in the display assembly is 2 to 1000 times of the first threshold length. In some embodiments of the present invention, the spacing between each of the light emitting units in the display assembly is 2, 3, 4, 5, 6, 7, 8, 9, 10, 11, 12, 13, 14, 15, 20, 25, 50, 100, 150, 200, 250, 300, 400, 500, 600, 700, 800, 900, or 1000 times of the first threshold length.

In some embodiments of the present invention, any one of the light emitting units in the display assembly has a shape of a rectangle, the rectangle has a first side and a second side; the first side is smaller than or equal to the second side, and the first threshold length is equal to the length of the first side.

In some embodiments of the present invention, any one of the light emitting units in the display assembly has a shape of a circle; the circle has a diameter, and the first threshold length is equal to the diameter.

In some embodiments of the present invention, any one of the light emitting units in the display assembly has a shape of a polygon; the polygon has a symmetry axis, and the first threshold length is equal to the length of the symmetry axis. In some embodiments of the present invention, the polygon is a regular polygon. In some embodiments of the present invention, the regular polygon is a regular hexagon.

In some embodiments of the present invention, any one of the light emitting units in the display assembly has a shape of a rectangle, a circle and/or a polygon, the rectangle has a first side and a second side, and the first side is smaller than or equal to the second side; the circle has a diameter; the polygon has a symmetry axis; the first threshold length is equal to the shortest of the length of the first side, the diameter, and the symmetry axis.

In some embodiments of the present invention, the substrate is a transparent substrate. In some embodiments of the present invention, the transparent substrate is a glass substrate.

In some embodiments of the present invention, the transistor unit in the display assembly is a thin film transistor.

In some embodiments of the present invention, the electrical connection is a metal connection. In some embodiments of the present invention, the metal connection is a conducting connection.

In some embodiments of the present invention, the display assembly is a self-luminous display assembly; in some embodiments of the present invention, the self-luminous display assembly comprises active light sources such as organic light emitting diodes (OLED), micro light emitting diodes (micro LED), quantum dot light emitter, or laser active light sources.

In some embodiments of the present invention, the transistor unit in the display assembly is provided between the light emitting units and the substrate. In some embodiments of the present invention, the transistor unit in the display assembly and the corresponding light emitting units are on a same plane.

In some embodiments of the present invention, the display assembly further comprises one or more sensors.

The present invention further provides a display device; in addition to the display assembly, the display device further comprises a collimating assembly; the collimating assembly comprises one or more collimating units. Any one of the collimating units has a shape of a circle which has a diameter. The diameter is at least two times of a second threshold length; the spacing between each of the collimating units is at least 400nm.

In some embodiments of the present invention, each of the diameter of the collimating units in the collimating assembly is 2, 3, 4, 5, 6, 7, 8, 9, 10, 11, 12 , 13, 14, 15, 20, 50, 100, 150, or 200 times of the second threshold length.

In some embodiments of the present invention, any one of the light emitting units in the display device has a shape of a rectangle, the rectangle has a first side and a second side; the first side is smaller than or equal to the second side, and the second threshold length is equal to the length of the first side.

In some embodiments of the present invention, any one of the light emitting units in the display device has a shape of a circle; the circle has a diameter, and the second threshold length is equal to the diameter.

In some embodiments of the present invention, any one of the light emitting units in the display device has a shape of a polygon; the polygon has a symmetry axis, and the second threshold length is equal to the length of the symmetry axis. In some embodiments of the present invention, the polygon is a regular polygon. In some embodiments of the present invention, the regular polygon is a regular hexagon.

In some embodiments of the present invention, the transistor unit in the display device is a thin film transistor.

In some embodiments of the present invention, the display assembly in the display device is a self-luminous display assembly; in some embodiments of the present invention, the self-luminous display assembly comprises an active light source such as organic light emitting diode (OLED), micro light emitting diode (micro LED), quantum dot light emitter, or laser active light source.

In some embodiments of the present invention, the collimating assembly in the display device is further capable of adjusting a direction of the collimating light.

In some embodiments of the present invention, any one of the collimating units in the display device is a lens or a liquid crystal spatial light modulator (LCSLM). In some embodiments of the present invention, the lens is a microlens or a flat metalens. In some embodiments of the present invention, the lens is a concave lens or a convex lens.

In some embodiments of the present invention, the microlens serves the function of collimating the direction of the emitted light from the at least one light emitting unit in the display assembly; and re-directing the at least two collimated light beams to intersect with each other and create a focus.

In some embodiments of the present invention, the flat metalens is a metasurface having nanometer scaled bumps which have the function of refracting light and changing the direction of the collimated light. As a result, the flat metalens has a function equivalent to a diopter and a function of collimating light. The flat metalens comprises multiple areas containing bumps to enable two collimated light beams to intersect and focus. In some embodiments of the present invention, the flat metalens comprises two separate areas having bumps to enable two collimated light beams to intersect at different locations, and thus creating image having multiple depths of field. In some embodiments of the present invention, the flat metalens enables at least two collimated light beams to intersect at different locations, and thus creating image having multiple depths of field by using a same or a different area having bumps.

In some embodiments of the present invention, the liquid crystal spatial light modulator comprises a plurality of liquid crystal cells; an alignment of a liquid crystal within the liquid crystal cells can be modulated by changing the applied voltage to the liquid crystal cells, such that the light emitting by each of the light emitting units is collimated and re-directed in a way that at least two collimated light beams can intersect with each other and create a focus. In some embodiments of the present invention, the liquid crystal spatial light modulator can alter the driving voltage of at least two liquid crystal cells, enabling at least two collimated light beams passing through the at least two liquid crystal cells to intersect with another light beam at different locations, and creating image having multiple depths of field. In some embodiments of the present invention, the liquid crystal spatial light modulator can alter a driving voltage of at least a different liquid crystal cell such that at least two collimated light beams can intersect at different locations thus creating image having multiple depths of field.

In some embodiments of the present invention, the collimating units in the display device have a curve surface. In some embodiments of the present invention, the curve surface in the display device is a spherical surface or an aspherical surface.

In some embodiments of the present invention, the curve surface of the collimating units in the display device is a portion of a spherical surface. The aforementioned spherical surface has a diameter 2, 3, 4, 5, 6, 7, 8, 9, 10, 15, 16, 17, 18, 19, or 20 times of the length of any one of the light emitting units. In some embodiments of the present invention, the aforementioned diameter of the spherical surface is 10 times of a length of any one of the light emitting units.

In some embodiments of the present invention, the display device is a transparent display or non-transparent display.

In some embodiments of the present invention, the display device is a near-eye display. In some embodiments of the present invention, the display device is a near-eye display capable of producing image having multiple depths of field. The display device can project a light on the collimating assembly via the light emitting units on the self-luminous display assembly, so the light passing through the collimating assembly can be collimated to form a collimated light. And the direction of the collimated lights from at least two light emitting units can be altered so they can intersect at different locations; and an image having multiple depths of field can be created.

In accordance with the prevent invention, the following technical effects can be achieved:
1. In the embodiment of the present invention, the light emitting units and the transistor unit in the display assembly are provided independently; the light emission efficiency can be maximized, and the area of the light emitting body subunit can be reduced to half or even one tenth of the area of the pixel in the prior art. This feature is advantageous for the transparent display and near-eye display.
2. In the embodiment of the present invention, the collimating assembly in the display device is provided to be compatible with the display assembly, which is also advantageous for the transparent and near-eye display.

### BRIEF DESCRIPTION OF THE DRAWINGS

FIG. 1A is a schematic view of the light emitting body with the corresponding transistor and capacitor of the display assembly of prior art.
FIG. 1B is a schematic view of the light emitting units with the corresponding transistor unit and capacitor unit of the display assembly in accordance with an embodiment of the present invention.
FIG. 2A is a schematic view of the light emitting units in accordance with an embodiment of the present invention.
FIG. 2B is a schematic view of the light emitting units having a plurality of light emitting body subunits in accordance with an embodiment of the present invention.
FIG. 3A is a schematic view of the display assembly in accordance with an embodiment of the present invention.
FIG. 3B is a schematic view of the collimating assembly in accordance with an embodiment of the present invention.
FIG. 3C is a schematic view of the display assembly and the collimating assembly in accordance with an embodiment of the present invention.

### DETAILED DESCRIPTION OF THE PREFERRED EMBODIMENTS

Embodiments of the present invention will now be described, by way of example only, with reference to the accompanying drawings.

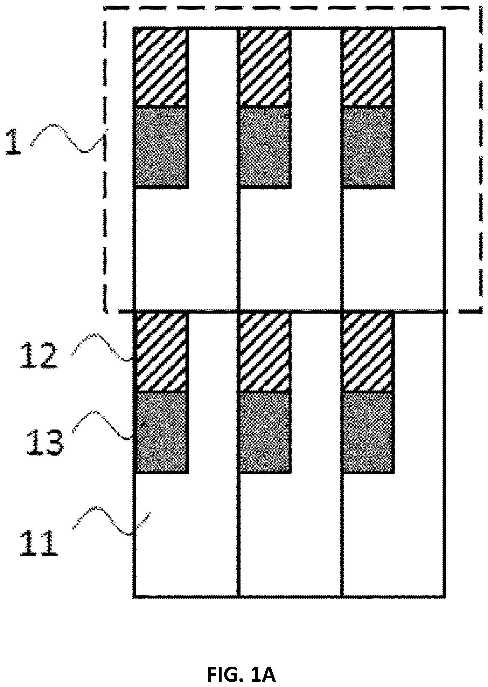

FIG. 1A illustrates a light emitting body 11, a transistor 12, and a capacitor 13 in a display assembly pixel 1 according to the prior art. When the light emitting body 11, the transistor 12 and the capacitor 13 are integrally provided, the light emitting body 11 will be partially blocked by the transistor 12 and the capacitor 13.

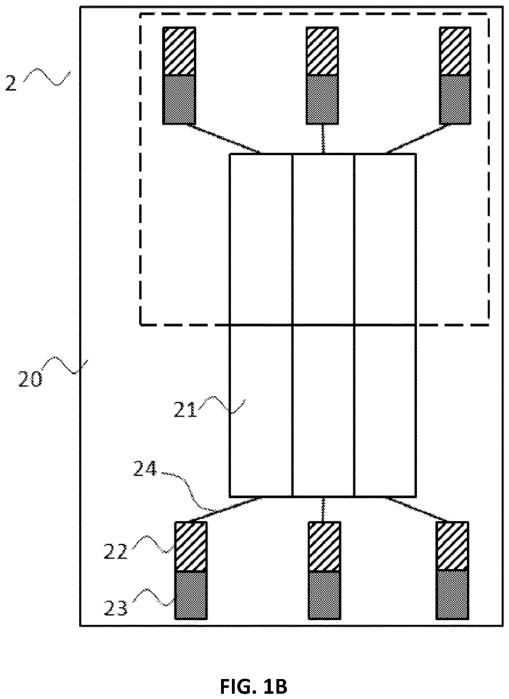

FIG. 1B illustrates a plurality of light emitting units 21 having a corresponding transistor unit 22 and a capacitor unit 23 of the display assembly 2 according to an embodiment of the present invention; in which the light emitting units 21, the transistor unit 22, and the capacitor unit 23 are independently provided on a side of a substrate 20. The light emitting units 21, the transistor unit 22, and the capacitor unit 23 are connected to a conductor 24. The light emitting units 21, the transistor unit 22 and the capacitor unit 23 are on a same plane. The dotted area in FIG. 1B indicates an area which is corresponsive to pixel 1 in FIG. 1A. For the purpose of comparison, relative to the pixel in the prior art, the light emission efficiency of the light emitting units 21 in the display assembly 2 of the present invention is greatly enhanced; in the meantime, the area of the light emitting units 21 can be drastically minimized.

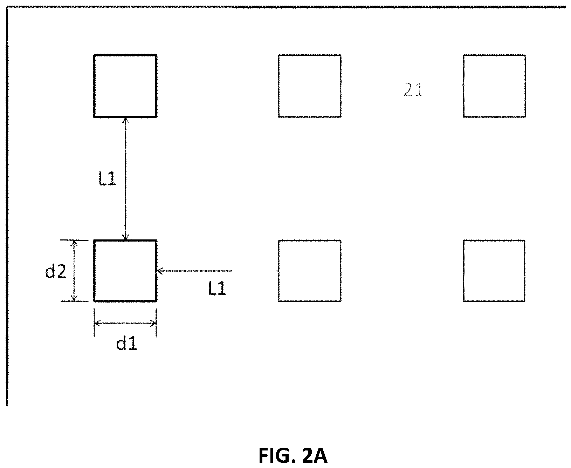

FIG. 2A is a schematic view of the light emitting units 21 according to an embodiment of the present invention. In this embodiment, the light emitting units 21 has a rectangular shape, the rectangular shape has a first side d1 and second side d2; and the first side d1 is smaller than or equal to the second side d2. And a spacing L1 between each of the light emitting units 21 is at least two times of the first side d1 (L1≥2d1).

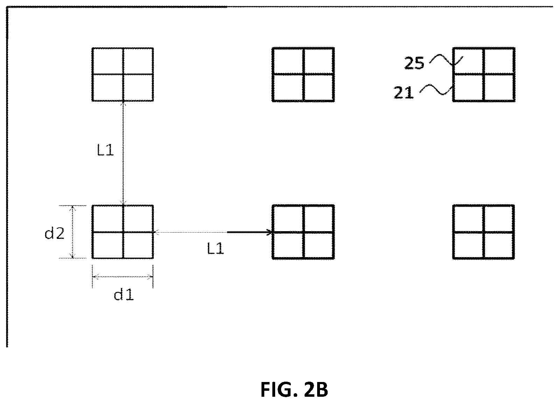

FIG. 2B is a schematic view of the light emitting units 21 according to an embodiment of the present invention, each of the light emitting units 21 comprises four light emitting body subunits 25; and each of the light emitting body subunits 25 comprises a red light (R) emitter, a green light (G) emitter, and a blue light (B) emitter. The arrangement order shown in FIG. 2B is just an example of the embodiment; light emitting units 21 may comprise different number of the light emitting body subunits 25.

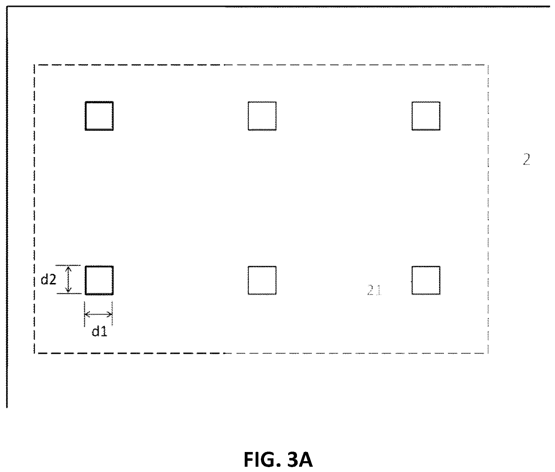

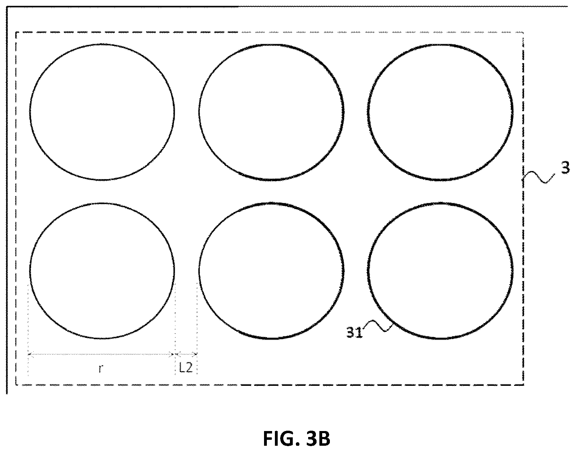

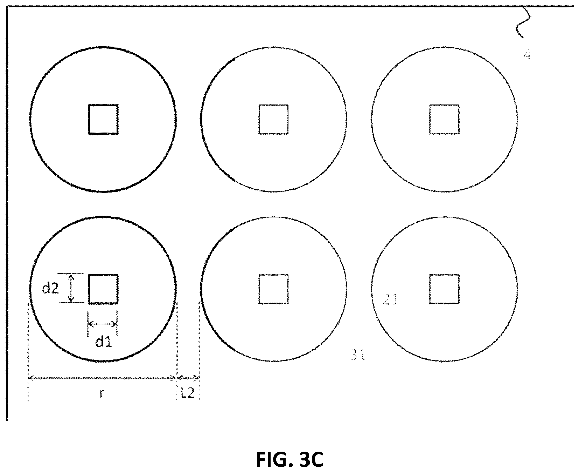

FIG. 3A is a schematic view of the display assembly 2 of the display device 4 display assembly 2. The display assembly 2 comprises a plurality of the light emitting units 21; FIG. 3B is a schematic view of a collimating assembly 3 in the display assembly 2. The collimating assembly 3 comprises a plurality of collimating units 31, each of the light emitting units 21 has a corresponding collimating unit 31. FIG. 3C is a schematic of the combination of FIG. 3A and FIG. 3B. Each diameter of the collimating units 31 is at least two time of a length of the first side d1 of the light emitting units 21; and a spacing L2 between each of the collimating units 31 is at least 400nm.

Although particular embodiments of the present invention have been described in detail for purposes of illustration, various modifications and enhancements may be made without departing from the spirit and scope of the present invention. Accordingly, the present invention is not to be limited except as by the appended claims.

## Claims

1. A display assembly, comprising:
a substrate;
a plurality of light emitting units; and
a transistor unit and a capacitor unit corresponding to each of the plurality of light emitting units,
wherein, each of the plurality of light emitting units and the corresponding transistor unit and capacitor unit are independently provided on a side of the substrate, and each of the plurality of light emitting units is electrically coupled to the corresponding transistor unit and the capacitor unit,
wherein, a spacing between each of the plurality of light emitting units is at least two times of a first threshold length.

2. The display assembly of claim 1, wherein the plurality of light emitting units has a shape of a rectangle having a first side and a second side, the first side is smaller than or equal to the second side, the first threshold length is equal to a length of the first side.

3. The display assembly of claim 1, wherein the plurality of light emitting units has a shape of a circle having a diameter, the first threshold length is equal to a length of the diameter.

4. The display assembly of claim 1, wherein the plurality of light emitting units has a shape of a polygon having a symmetry axis, the first threshold length is equal to a length of the symmetry axis.

5. The display assembly of claim 1, wherein the plurality of light emitting units has a shape of a rectangle, a circle, and/or a polygon, the rectangle has a first side and a second side, and the first side is smaller than or equal to the second side; the circle has a diameter, the polygon has a symmetry axis, the first threshold length is equal to the shortest of a length of the first side, a length of the diameter, and a length of the symmetry axis.

6. The display assembly of claim 1, wherein each of the plurality of light emitting units comprises one or more red light emitters, green light emitters, or blue light emitters.

7. The display assembly of claim 1, wherein each of the plurality of light emitting units comprises one or more light emitting body subunits, each of the one or more light emitting body subunits comprises a red light emitter, a green light emitter, and a blue light emitter.

8. The display assembly of claim 7, wherein one of the plurality of light emitting units comprises one to six light emitting body subunits.

9. The display assembly of claim 1, wherein the transistor unit is provided between a corresponding light emitting units and the substrate.

10. The display assembly of claim 1, wherein the transistor unit and the corresponding light emitting units are on a same plane.

11. The display assembly of claim 1, wherein the transistor unit is a thin film transistor.

12. The display assembly of claim 1, further comprising an organic light emitting diode, a micro light emitting diode, a quantum dot light emitter or a laser active light source.

13. A display device comprising the display assembly of claim 1 and a collimating assembly; wherein the collimating assembly comprises a plurality of collimating units, the plurality of collimating units has a shape of a circle which has a diameter, the diameter is at least two times of a second threshold length, a spacing in between each of the plurality of collimating units is at least 400nm.

14. The display device of claim 13, wherein the plurality of light emitting units has a shape of a rectangle, the rectangle comprises a first side and a second side, and the first side is smaller than or equal to the second side, and the second threshold length is equal to a length of the first side.

15. The display device of claim 13, wherein the plurality of light emitting units has a shape of a circle having a diameter, the second threshold length is equal to a length of the diameter.

16. The display device of claim 13, wherein the plurality of light emitting units has a shape of a polygonal having a symmetry axis, the second threshold length is equal to a length of the symmetry axis.

17. The display device of claim 13, wherein the transistor unit in the display assembly is a thin film transistor.

18. The display device of claim 13, wherein the display assembly is an organic light emitting diode, a micro light emitting diode, a quantum dot light emitter or a laser active light source.

19. The display device of claim 13, wherein the collimating assembly further comprises a means for changing a direction of a collimating light.

20. The display device of claim 13, wherein the plurality of collimating units is a lens or a liquid crystal spatial light modulator.

21. The display device of claim 20, wherein the lens is a microlens or a flat metal ens.

22. The display device of claim 13, wherein the plurality of collimating units has a curve surface.

23. The display device of claim 22, wherein the curve surface is a spherical surface or an aspherical surface.

24. The display device of claim 13, wherein the display device is a transparent display or a non-transparent display.

25. The display device of claim 13, wherein the display device is a near-eye display.
